# EUROPÄISCHE PATENTSCHRIFT

(11) **EP 0 617 451 B1**
(45) Veröffentlichungstag und Bekanntmachung des Hinweises auf die Patenterteilung: **26.03.1997**
(21) Anmeldenummer: 94102610.6
(22) Anmeldetag: 22.02.1994
(51) Int. Cl.: H01J 37/05, H01J 49/46

(54) **Abbildendes Elektronenenergiefilter**
Imaging electron energy filter
Filtre en énergie d'électrons, produisant une image

(30) Priorität: 26.03.1993 DE 4310559
(43) Veröffentlichungstag der Anmeldung: 28.09.1994
(73) Patentinhaber: Carl Zeiss, D-89520 Heidenheim (Brenz) (DE)
(72) Erfinder: Rose, Harald, Prof. Dr., D-64287 Darmstadt (DE); Uhlemann, Stephan, D-64297 Darmstadt (DE); Weimer, Eugen, Dr., D-73457 Essingen (DE)

(56) Entgegenhaltungen:
- DE-A- 3 532 698
- NUCLEAR INSTRUMENTS AND METHODS, Bd.154, Nr.1, August 1978, AMSTERDAM NL Seiten 127 - 149 W. MAMPE ET AL. 'The double focusing iron-core electron-spectrometer "BILL" for high resolution (n,e-) measurements at the high flux reactor in Grenoble.'
- NUCLEAR INSTRUMENTS & METHODS IN PHYSICS RESEARCH, SECTION - A: ACCELERATORS, SPECTROMETERS, DETECTORS AND ASSOCIATED EQUIPMENT, Bd.298, Nr.1/3, 1. Dezember 1990, AMSTERDAM NL Seiten 171 - 178 R. DEGENHARDT ET AL. 'A compact aberration-free imaging filter with inside energy selection.'

## Beschreibung

Abbildende Elektronenenergiefilter werden bei Transmissionselektronenmikroskopen verwendet, um den Kontrast der Objektabbildung oder von Beugungsdiagrammen durch die Auswahl von Elektronen eines bestimmten Energiebereiches zu verbessern. Auch die Registrierung von Elementverteilungen und Energieverlustspektren ist mit derartigen Filtersystemen möglich.

Aus der US-A1-4 740 704 und der US-A1-4 760 261 sind Filtersysteme bekannt, die als dispersive Elemente drei oder vier homogene Magnetfelder verwenden. Diese Filter sind geradsichtig, d.h. die optischen Achsen der einfallenden und austretenden Elektronenbahnen sind koaxial zueinander. Dadurch sind diese Filter gut in Elektronenmikroskopen, in denen aus Stabilitätsgründen die optische Achse der Elektronenbahnen üblicherweise vertikal von oben nach unten verläuft, einsetzbar. Zur Fokussierung der Elektronen in Richtung der magnetischen Umlenkfelder sind die Ein- und Austrittskanten der Magnetpolschuhe zur Wellenfrontrichtung der Elektronenstrahlen geneigt, wodurch in Magnetfeldrichtung wirksame Quadrupolanteile entstehen.

Die Dispersion in der energieselektiven Ebene derartiger Spektrometer beträgt etwa 1-2 µm pro eV bei einer Energie der Elektronen von 100 keV. Dadurch sind Energiebreiten von etwa 1-2 eV einstellbar. Da die Dispersion in den homogenen Magnetfeldern mit zunehmender Elektronenenergie abnimmt, sind zur Einstellung gleicher minimaler Energiebreiten bei höheren Elektronenenergien Filter mit wesentlich größeren Dimensionen erforderlich. Dies führt bei Verwendung in einem Elektronenmikroskop zu einer erheblichen Verlängerung der elektronenoptischen Säule, wodurch deren mechanische Stabilität verringert wird. Außerdem nehmen gleichzeitig die geometrischen Bildfehler zu, da bei größer dimensionierten Filtern außeraxiale Strahlen weiter entfernt von der optischen Achse geführt sind als bei Filtern mit kleinerer Dimension.

Magnetische Spektrometer mit inhomogenen Umlenkfeldern sind beispielsweise aus Review of Scientific Instruments, Vol. 32, 1314 (1961) für die Elektronenspektroskopie bekannt. Das Spektrometer weist einen einzigen Sektormagneten auf, dessen Polschuhflächen zueinander geneigt sind. Das daraus resultierende Gradientenfeld bewirkt zusätzlich zur Strahlumlenkung eine Fokussierung senkrecht zur Ebene der Elektronenstrahlachse. Bei diesem Spektrometer sind jedoch die optischen Achsen beim Einfall bzw. Austritt aus dem Filter nicht koaxial zueinander. Dies führt beim Einsatz in Elektronenmikroskopen zu instabilen Gesamtaufbauten.

In Nuclear Instruments & Methods, Band 154, Nr. 1, August 1978, Seiten 127-149 ist weiterhin ein doppelfokussierendes Spektrometer beschrieben, das direkt aneinander anschließende homogene und inhomogene Magnetfelder aufweist. Auch bei diesem Spektrometer sind jedoch die optischen Achsen beim Einfall bzw. Austritt aus dem Spektrometer nicht koaxial zueinander. Außerdem handelt es sich um ein Spektrometer, das lediglich eine dispersive Abbildung einer Eingangsebene in eine Ausgangsebene erzeugt. Eine stigmatische, achromatische Abbildung einer zweiten Eingangsebene in eine zweite Ausgangsebene findet nicht statt.

Der Einsatz von Spektrometern mit inhomogenen Umlenkfeldern in Elektronenmikroskopen ist beispielsweise in Optik, Vol. 71, Seite 73 (1985) vorgeschlagen. Diese Arbeit befaßt sich jedoch im wesentlichen mit den Bahnverläufen in Magnetfeldern unterschiedlicher Inhomogenität. Konkrete Vorschläge für die Gestaltung derartiger Filter sind nicht entnehmbar.

Desweiteren ist in Optik, Vol. 38, Seite 502 (1973) und in Optik, Vol. 40, Seite 141, (1974) bereits der Einsatz zweier inhomogener Umlenkfelder in Elektronenstrahlgeräten vorgeschlagen worden. Dieses System dient jedoch zur Korrektur von Öffnungsfehlern. Außerdem sind auch hier die optischen Achsen der Elektronenstrahlen vor dem Eintritt ins erste Umlenkfeld und nach dem Austritt aus dem zweiten Umlenkfeld nicht koaxial zueinander.

Es soll ein magnetisches Elektronenenergiefilter geschaffen werden, das auch bei höheren Elektronenenergien, insbesondere über 120 keV, einen kompakteren Aufbau bei gleichzeitig kleiner minimaler Energiebreite gestattet.

Dazu wird ein abbildendes Elektronenenergiefilter vorgeschlagen, das aus mehreren Sektormagneten zur Strahlumlenkung besteht. Mindestens ein erster Sektormagnet weist ein homogenes und mindestens ein zweiter Sektormagnet ein inhomogenes Umlenkfeld auf.

Durch die Verwendung inhomogener Umlenkfelder lassen sich relativ große Umlenkwinkel realisieren, die Werte über 120° annehmen können. Da die Dispersion mit der Bahnlänge innerhalb der Umlenkfelder zunimmt, ist die Dispersion bei großen Umlenkwinkeln entsprechend groß, ohne daß größere Krümmungsradien und damit größere Abmessungen erforderlich sind Eine weitere Reduktion der Abmessungen ist dadurch möglich, daß ein Sektormagnet ein im wesentlichen homogenes Umlenkfeld ausweist. Denn dieses homogene Umlenkfeld kann von dem Elektronenstrahl zweimal in unterschiedlichen Richtungen durchlaufen werden.

Für die Gestaltung der Sektormagnete mit inhomogenen Umlenkfeldern hat es sich als besonders zweckmäßig erwiesen, zwei zueinander geneigte, abgestumpfte Kegelsektorflächen als Polschuhe vorzusehen. Zwischen den Flächen des stumpfen Doppelkegels entsteht dabei ein rotationssymmetrischer, radial nach außen anwachsender keilförmiger Spalt.

Ein vorteilhaftes Ausführungsbeispiel der Erfindung weist einen ersten Sektormagneten mit einem homogenen Umlenkfeld und zwei weitere Sektormagneten mit jeweils inhomogenen Umlenkfeldern auf. Zwischen den Sektormagneten entstehen dabei feldfreie Räume, in denen Multipolelemente zur Korrektur der Bildfehler zweiter Ordnung angeordnet sein können.

Eine besonders kompakte Anordnung ergibt sich, wenn die Abstände zwischen den Sektormagneten und die Umlenkwinkel so gewählt sind, daß sich die optische Achse der ein- und austretenden Elektronen im homogenen Umlenkfeld berührt oder zweimal kreuzt. Dadurch wird der Abstand zwischen dem Filtereingang und dem Filterausgang minimiert.

Für eine Verwendung des Elektronenenergiefilters in einem Elektronenmikroskop sollte die optische Achse der Elektronenbahnen beim Eintritt in und beim Austritt aus dem Filter koaxial zu sich selbst verlaufen. Dadurch ist das Filter optimal an den aus Stabilitätsgründen üblicherweise vertikalen Aufbau des Elektronenmikroskops angepaßt.

Die Sektormagnete sollten symmetrisch zu einer Ebene angeordnet sein, die senkrecht zur Ebene steht, in der die gekrümmte optische Achse verläuft. Beim Durchlauf der Elektronen durch das gesamte Filter verschwindet dann bereits ein Teil der Abbildungsfehler aus Symmetriegründen.

Das erfindungsgemäße Elektronenenergiefilter ist besonders einfach herstellbar, wenn die Polschuhkanten der Sektormagnete an den Ein- und Austrittsflächen des Elektronenstrahlbündels gerade sind. Außerdem sollten die Ein- und Austrittswinkel zwischen der optischen Achse und den Polschuhkanten der Sektormagnete beim ersten Eintritt in das homogene Umlenkfeld, beim Eintritt in und beim Austritt aus den inhomogenen Umlenkfeldern und beim letzten Austritt aus dem homogenen Umlenkfeld jeweils 90° betragen. Dadurch werden Brechungen des Elektronenstrahlbündels beim Eintritt in die bzw. beim Austritt aus den Magnetfeldern vermieden. Der Bahnverlauf ist dadurch relativ glatt und es treten keine Fokussiereffekte an den Rändern der Sektormagnete auf. Dadurch ist das Filter relativ unempfindlich gegen Dejustierungen.

Zur Erhaltung der durch die symmetrische Anordnung der Sektormagnete eingestellten Symmetrie sollten auch die Multipollinsen, die zur Korrektur der Abbildungsfehler dienen, symmetrisch zur Symmetrieebene angeordnet sein. Jeweils zwei zueinander symmetrisch angeordnete Multipollinsen sind dabei über eine gemeinsame Steuerung identisch erregbar.

Vor der Eingangsbildebene vor dem ersten Sektormagneten und hinter der dazu symmetrischen Ausgangsbildebene sollte zusätzlich jeweils eine Multipollinse angeordnet sein, die aus der Überlagerung eines Quadrupols und eines Hexapols besteht. Das Quadrupolfeld und das Hexapolfeld sollten unabhängig voneinander einstellbar sein. Durch Variation der Quadrupollinsen kann in Verbindung mit dem kontinuierlichen Quadrupol in den inhomogenen Sektormagneten die Fokussierung in der zur Bahnebene senkrechten Richtung beliebig eingestellt werden. Die Hexapolfelder dienen wiederum, wie die zwischen den einzelnen Sektormagneten angeordneten Hexapolfelder, zur Korrektur der Bildfehler und zur Fokussierung des Elektronenstrahls in der Bahnebene. Bei geeigneter Positionierung der Multipolelemente entlang der Elektronenbahn ist mit insgesamt sieben Hexapolen zwischen der Eingangsbildebene und der Ausgangsbildebene, von denen ein Hexapol zwischen dem zweiten und dritten Sektormagneten in der Symmetrieebene angeordnet ist, und den beiden in der Eingangsbildebene und der Ausgangsbildebene angeordneten überlagerten Multipolen ein Energiefilter möglich, das bezüglich sämtlicher geometrischer Bildfehler und der in der jeweiligen Betriebsart wesentlichen energieabhängigen Fehler zweiter Stufe korrigiert ist. Die Eingangsbildebene ist dann stigmatisch und achromatisch mit hoher Auflösung in die Ausgangsbildebene abgebildet. Außerdem verschwindet aus Symmetriegründen die Verzeichnung dritter Ordnung des Filters.

Weitere vorteilhafte Ausgestaltungen und Anwendungen der Erfindung sind durch die Merkmale der abhängigen Ansprüche gegeben. Für die Verwendung des Elektronenenergiefilters in Verbindung mit einem Elektronenmikroskop, insbesondere mit einem Transmissionselektronenmikroskop, ist noch von Bedeutung, daß der Abstand zwischen den Bildebenen und den Crossover-Ebenen, d.h. der Abstand zwischen der Eingangsbildebene und der Eingangsbeugungsebene sowie der Abstand zwischen der Ausgangsbildebene und der Ausgangsbeugungsebene, an die durch das elektronenoptische Abbildungssystem des Elektronenmikroskops gegebenen Abstände angepaßt ist. Die externen Quadrupole haben außerdem den Vorteil, daß damit ein durch eventuelle Baufehler verursachter Astigmatismus korrigiert werden kann.

Im folgenden werden Einzelheiten der Erfindung anhand des in den Figuren dargestellten Ausführungsbeispiels näher erläutert. Im einzelnen zeigen:
- Figur 1: einen Schnitt durch ein bevorzugtes Ausführungsbeispiel des erfindungsgemäßen Filters in einer die optische Achse enthaltenden Ebene;
- Figur 2: einen Schnitt durch einen Sektormagneten mit geneigten Polschuhflächen in einer zur Figur 1 senkrechten Ebene.

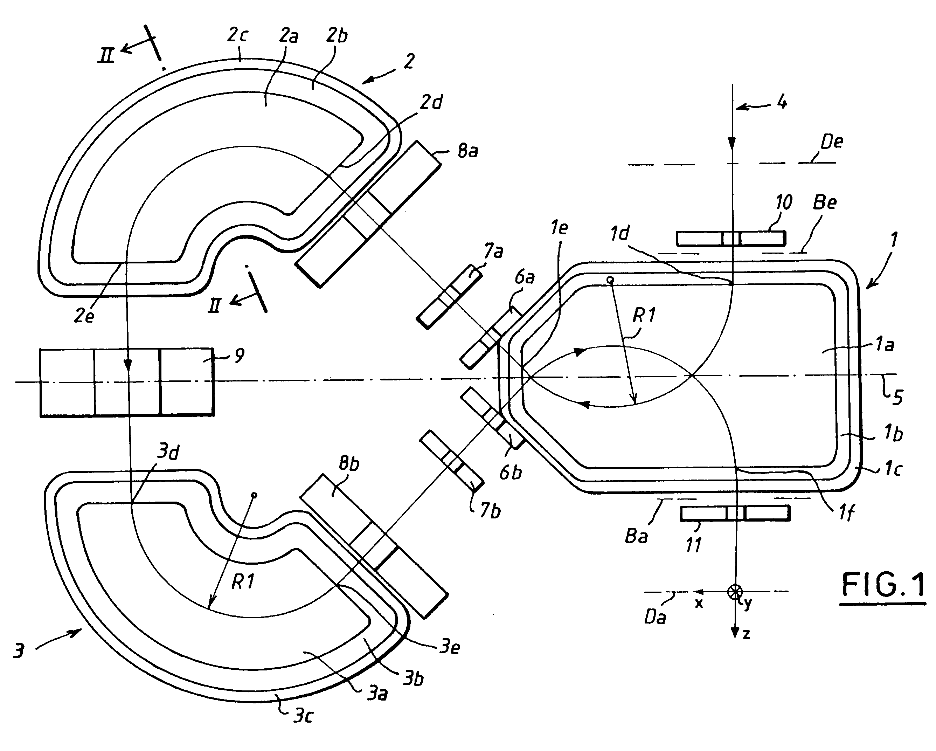

Das in der Figur 1 dargestellte Elektronenenergiefilter besteht aus drei Sektormagneten (1, 2, 3), von denen jeweils nur die unterhalb der Zeichenebene liegenden Polschuhe (1a, 2a, 3a) dargestellt sind. Die optische Achse des Filters ist mit (4) bezeichnet. Diese optische Achse (4) ist identisch mit dem zentralen Strahl des Elektronenbündels für eine vorgegebene Sollenergie. Der genaue Bahnverlauf für ein einzelnes Elektron ist aufgrund der Dispersion in den Magnetsektoren von der jeweiligen Elektronenenergie abhängig und aus Gründen der Übersichtlichkeit hier nicht dargestellt.

Der zentrale Elektronenstrahl (optische Achse (4)) tritt in das Elektronenenergiefilter entlang einer vertikalen Achse von oben ein. Bei Installation des Filters in einem hier nicht dargestellten Transmissionselektronenmikroskop mit vertikal von oben nach unten verlaufenden Elektronenbahnen fällt die optische Achse (4) des Filters beim Ein- und beim Austritt aus dem Filter mit der optischen Achse des Elektronenmikroskops zusammen. Die Eingangsbildebene (Be) fällt dabei mit einer Zwischenbildebene des Elektronenmikroskops und die Eingangsbeugungsebene (De) mit einer Beugungsebene des Elektronenmikroskopes zusammen. Die genaue Anordnung des Filters im abbildungsseitigen Bereich des Elektronenmikroskops ist in der US-A1-4 812 652 ausführlich beschrieben, auf die in dieser Hinsicht ausdrücklich verwiesen sei.

Die Polschuhe (1a) des ersten Sektormagneten (1) weisen im Inneren ebene parallele Polschuhflächen auf. Die Polschuhe (2a, 3a) der beiden anderen Sektormagnete (2,3) sind abgestumpfte Doppelkegel. In den Randbereichen der Polschuhe (1a, 2a, 3a) sind umlaufende Nuten (1b, 2b, 3b) zur Aufnahme der hier nicht dargestellten Erregerspulen vorgesehen. Durch das Einlegen der Erregerspulen in die Nuten (1b, 2b, 3b) und die dadurch entstehenden umlaufenden Randbereiche (1c, 2c, 3c) sind die außerhalb der Sektormagnete auftretenden Streufelder stark reduziert.

Im ersten Sektormagnet (1) ist ein homogenes Umlenkfeld erzeugt. Dazu weist der Sektormagnet (1) zwei Polschuhe mit ebenen Polschuhflächen auf, die in zwei zur Zeichenebene in Figur 1 parallelen Ebenen angeordnet sind. Das entlang der optischen Achse (4) senkrecht zur Eintrittskante (1d) des Umlenkfeldes mit der Sollenergie eintretende Elektronen wird zwischen den Polschuhen (1a) durch das senkrecht zur Zeichenebene stehende Magnetfeld auf eine Kreisbahn mit einem Krümmungsradius (R1) umgelenkt. Zwischen dem Eintritt an der Eintrittskante (1d) und dem Austritt an der Austrittskante (1e) durchläuft die optische Achse (4) einen entsprechenden Kreisbogenabschnitt über einen Winkel von etwa 135°. Die optische Achse des aus dem ersten Sektormagneten austretenden Elektronenstrahlbündels ist daher gegenüber der optischen Achse des eintretenden Elektronenstrahlbündels um einen Umlenkwinkel φ = 135° umgelenkt. Durch den relativ großen Umlenkwinkel φ ist die Bahnlänge des Elektronenstrahlbündels innerhalb des ersten Umlenkbereiches für einen vorgegebenen Umlenkradius (R1) und damit auch die Dispersion innerhalb des ersten Umlenkbereiches relativ groß.

Durch die Neigung zwischen der optischen Achse (4) und der Austrittskante (1e) des homogenen Sektormagneten (1) wird das Elektronenstrahlbündel in Magnetfeldrichtung fokussiert. Diese fokussierende Wirkung kann alternativ durch zusätzliche Quadrupole hinter dem Sektormagneten (1) erzeugt werden, wenn die optische Achse (4) senkrecht zur Austrittskante (1e) steht.

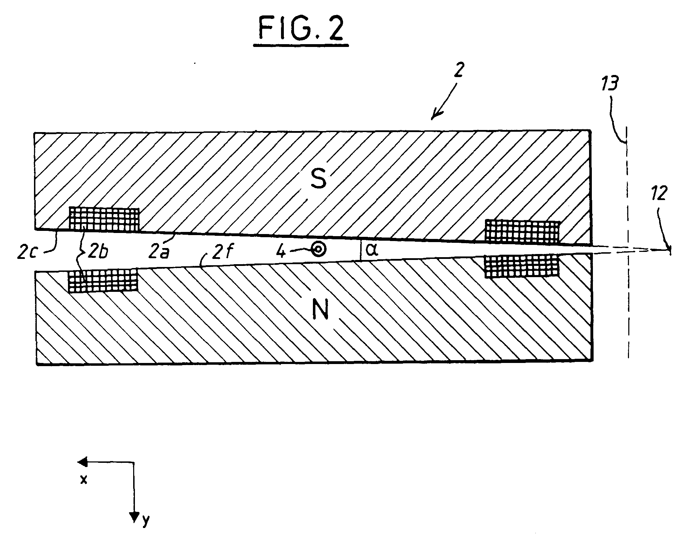

Nach Austritt aus dem ersten Umlenkfeld durchlaufen die Elektronen zunächst einen feldfreien Zwischenraum, in dem drei Hexapole (6a, 7a, 8a) angeordnet sind und treten anschließend in das Umlenkfeld des zweiten Sektormagneten (2) ein. Das Umlenkfeld innerhalb des zweiten Sektormagneten (2) ist ein inhomogenes magnetisches Gradientenfeld, das zwischen zwei zueinander geneigten Polschuhflächen (2a, 2f) (siehe Figur 2) erzeugt wird.

In der zur Zeichenebene in Figur 1 senkrechten Schnittdarstellung nach Figur 2 ist die optische Achse der Elektronenbahnen wiederum mit (4) bezeichnet. Die in die Vertiefungen (2b) der kegelförmigen Polschuhflächen (2a, 2f) eingelassenen Spulenkörper sind durch die kreuzgitterartige Schraffur angedeutet. Der Neigungswinkel α zwischen den beiden Fallinien der Kegelflächen (2a, 2f) beträgt ca. 4°. Der gesamte Sektormagnet (2) ergibt sich durch Rotation um die zur Ebene der optischen Achse (4) senkrechten Achse (13). Der Schnittpunkt (12) der beiden Fallinien der Kegelflächen (2a, 2f) liegt, von der optischen Achse (4) gesehen, hinter der Achse (13).

Durch die Neigung der beiden Polschuhflächen (2a, 2f) entsteht in dem keilförmigen Spalt zwischen den Polschuhen ein Gradientenfeld. Die in Figur 2 nicht eingezeichneten Feldlinien sind Kreisbögenabschnitte um den Schnittpunkt (12) der Fallinien der Kegelflächen (2a, 2f), wobei die Feldstärke aufgrund der nach außen hin (positive x-Richtung, vergleiche die zueinander korrespondierenden Koordinatensysteme in Figur 1 und 2) zunehmenden Spaltdicke abnimmt. Das Gradientenfeld hat die Wirkung eines Dipolfeldes, dem zusätzlich ein Quadrupolfeld überlagert ist. Das Dipolfeld bewirkt wie das Dipolfeld eines homogenen Umlenkfeldes eine Umlenkung der Elektronenbahn auf einem Kreisbahnabschnitt und eine Fokussierung in x-Richtung. Der überlagerte Quadrupolanteil bewirkt zusätzlich eine Fokussierung des Elektronenstrahlbündels in der zur Zeichenebene in Figur 1 senkrechten y-Richtung.

Wie der Figur 1 weiterhin entnehmbar ist, steht die optische Achse (4) beim Eintritt in das zweite Umlenkfeld an der Eintrittskante (2d) und beim Austritt aus dem zweiten Umlenkfeld an der Austrittskante (2e) jeweils senkrecht zur Ein- bzw. Austrittskante (2d, 2e). Nach dem Austritt aus dem zweiten Umlenkfeld verläuft die optische Achse des Elekronenstrahls parallel zur optischen Achse vor dem Eintritt ins erste Umlenkfeld und durchläuft nachfolgend das ebenfalls inhomogene Gradientenfeld des dritten Sektormagneten (3) und ein zweites Mal das homogene Umlenkfeld des ersten Sektormagneten (1), an dem er an der Austrittskante (1f) austritt.

Das gesamte Filter ist zu einer zur Bahnebene (Zeichenebene in Figur 1) senkrechten Mittelebene (5) symmetrisch aufgebaut. Der Aufbau des dritten Sektormagneten (3) ergibt sich daher aus dem Aufbau des zweiten Sektormagneten (2) durch Spiegelung an der Symmetrieebene (5). Zwischen dem dritten Sektormagneten (3) und dem ersten Sektormagneten (1) sind drei weitere Hexapole (8b, 7b, 6b) bezüglich der Symmetrieebene (5) symmetrisch zu den Hexapolen (8a, 7a, 6a) angeordnet. Ein weiterer Hexapol (9) ist zwischen dem zweiten Sektormagneten (2) und dem dritten Sektormagneten (3) in der Symmetrieebene (5) vorgesehen. An dieser Stelle liegt auch ein reelles Zwischenbild der Eingangsbildebene (Be).

Vor der Eingangsbildebene (Be) des Filters und hinter der dazu bezüglich der Symmetrieebene (5) gespiegelten Ausgangsbildebene (Ba) sind jeweils noch zwei weitere Multipolelemente (10, 11) angeordnet. Jedes dieser beiden Multipolelemente (10, 11) besteht aus einer Überlagerung eines Quadrupols mit einem Hexapol, die jeweils unabhängig voneinander erregbar sind. Das Elektronenenergiefilter bildet die Eingangsbildebene (Be) stigmatisch und achromatisch in die Ausgangsbildebene (Ba) ab. Gleichzeitig bildet das Filter die Eingangsbeugungsebene (De) dispersiv in die Ausgangsbeugungsebene (Da) ab. Die Abstände zwischen den einzelnen Sektormagneten (1, 2, 3) sind an den in den drei zugehörigen Umlenkbereichen identischen Umlenkwinkel derart angepaßt, daß sich die Elektronenbahnen beim ersten Durchgang durch den ersten Sektormagneten (1) und beim zweiten Durchgang durch den Sektormagneten (1) zweimal kreuzen. Dadurch ist der Abstand zwischen der Eingangsbildebene (Be) und der Ausgangsbildebene (Ba), gemessen entlang der optischen Achse des Elektronenmikroskops, besonders klein. Die elektronenoptische Säule des Mikroskops wird daher durch den Einbau des erfindungsgemäßen Filters nur unwesentlich verlängert und die mechanische Stabilität des Gesamtsystems nicht wesentlich negativ beeinflußt.

Ohne Änderung der in den Multipolkomponenten (10, 11) erzeugten Felder sind die wesentlichen Fehler in der (dispersiven) Beugungsebene korrigierbar. Insgesamt können durch geeignete Einstellung der neun Multipolkomponenten (6a, 7a, 8a, 9, 8b, 7b, 6b, 10, 11) sämtliche geometrischen Bildfehler zweiter Ordnung und die wesentlichen energieabhängigen Fehler zweiter Stufe korrigiert werden.

Da der gesamte Filteraufbau symmetrisch zur Mittelebene (5) ist, brauchen jedoch nicht alle Multipolkomponenten separat ansteuerbar sein. Vielmehr ist es zur Vermeidung eines zu großen gerätetechnischen Aufwandes und eines zu großen Justieraufwandes vorteilhaft, jeweils symmetrisch zueinander angeordnete Multipolelemente sowie den zweiten und dritten Sektormagneten jeweils über eine gemeinsame Stromsteuerung zu erregen.

Aufgrund der guten Korrektionseigenschaften des Filters und der auch bei höheren Elektronenenergien relativ großen Dispersion erlaubt das Filter durch Einfügen einer Selektionsblende in der Ausgangsbeugungsebene (Da) eine sehr gute Energieauflösung im Bild. Bei einer Elektronenenergie von 200 keV beträgt die Gesamtdispersion des Filters noch etwa 10 µm pro eV, so daß mit einer Selektionsblende von 1 µm Öffnungsdurchmesser noch Energiebreiten von 0,1 - 0,2 eV einstellbar sind. Durch die hohe Energieauflösung werden auch der die Auflösung begrenzende Farbfehler des Objektivs des Elektronenmikroskops reduziert. Dies führt zu einer Verbesserung der Auflösung und des Bildkontrastes, wobei der Auflösungsgewinn bei unkorrigierten Objektiven bis zu ca. 20% und bei sphärisch korrigerten Objektiven bis zu einem Faktor drei betragen kann.

Durch den glatten Bahnverlauf, insbesondere durch die Vermeidung von Brechungen an den Rändern der Sektormagneten, ist das Filter auch besonders unempfindlich gegen Dejustierungen.

## Patentansprüche

1. Abbildendes Elektronenenergiefilter, das eine erste Eingangsebene (Be) achromatisch in eine erste Ausgangsebene (Ba) und gleichzeitig eine zweite Eingangsebene (De) dispersiv in eine zweite Ausgangsebene (Da) abbildet, mit mehreren Sektormagneten (1, 2, 3) zur Strahlumlenkung, wobei mindestens ein erster Sektormagnet (1) ein homogenes Umlenkfeld aufweist, dadurch gekennzeichnet, daß mindestens ein zweiter Sektormagnet (2, 3) ein inhomogenes Umlenkfeld aufweist.

2. Elektronenenergiefilter nach Anspruch 1, wobei mindestens drei Sektormagnete (1, 2, 3) vorgesehen sind und mindestens zwei Sektormagnete (2, 3) jeweils ein inhomogenes Umlenkfeld aufweisen.

3. Elektronenenergiefilter nach Anspruch 1 oder 2, wobei die optische Achse (4) beim Eintritt in und beim - Austritt aus dem Elektronenenergiefilter das homogene Umlenkfeld durchläuft und sich im homogenen Umlenkfeld berührt oder zweimal kreuzt.

4. Elektronenenergiefilter nach einem der Ansprüche 1 bis 3, wobei der zweite oder der zweite und der dritte Sektormagnet (2, 3) jeweils einen von einem Schnittpunkt (12) ausgehenden, radial zunehmenden Spalt zwischen den Polschuhflächen (2a, 2f) aufweist.

5. Elektronenenergiefilter nach Anspruch 4, wobei die Polschuhe des zweiten und dritten Sektormagneten (2, 3) als abgestumpfte Kegelsektorflächen (2a, 2f) ausgebildet sind.

6. Elektronenenergiefilter nach einem der Ansprüche 1 bis 5, wobei die optische Achse (4) beim Eintritt in und beim Austritt aus dem Filter koaxial verläuft und die Sektormagnete (1, 2, 3) symmetrisch zu einer senkrecht zur Ebene der optischen Achse (4) stehenden Ebene (5) angeordnet sind.

7. Elektronenenergiefilter nach einem der Ansprüche 1 bis 6, wobei die Sektormagnete (1, 2, 3) jeweils gerade Ein- und Austrittskanten (1d, 2d, 3d, 1e, 2e, 3e, 1f) aufweisen und die Ein- und Austrittswinkel zwischen der optischen Achse (4) und den Ein- und Austrittskanten (1d, 2d, 2e, 3d, 3e, 1f) der Sektormagnete (1, 2, 3) beim ersten Eintritt in das homogene Umlenkfeld, beim Eintritt in und beim Austritt aus den inhomogenen Umlenkfeldern und beim letzten Austritt aus dem homogenen Umlenkfeld jeweils 90° betragen.

8. Elektronenenergiefilter nach Anspruch 6 oder 7, wobei außerhalb der magnetischen Umlenkfelder mehrere Multipollinsen (6a, 7a, 8a, 9, 8b, 7b, 6b) symmetrisch zur Symmetrieebene (5) angeordnet sind, und wobei jeweils symmetrisch zueinander angeordnete Multipollinsen (6a, 6b; 7a, 7b; 8a, 8b) hinsichtlich ihrer Erregung miteinander gekoppelt sind.

9. Elektronenenergiefilter nach einem der Ansprüche 6 bis 8, wobei in Richtung der einfallenden optischen Achse (4) vor einer Eingangsbildebene (Be) und hinter der dazu symmetrischen Ausgangsbildebene (Ba) Multipollinsen (10, 11) angeordnet sind, die jeweils aus einer Überlagerung eines Quadrupols und eines Hexapols bestehen, und wobei das Quadrupolfeld und das Hexapolfeld unabhängig voneinander einstellbar sind.

10. Elektronenenergiefilter nach Anspruch 8, wobei die zwischen den Sektormagneten (1, 2, 3) angeordneten Multipollinsen (6a, 7a, 8a, 9, 8b, 7b, 6b) als Hexapole ausgebildet sind.

11. Elektronenenergiefilter nach einem der Ansprüche 1 bis 10, wobei die Umlenkwinkel in jedem Umlenkfeld größer als 90°, vorzugsweise größer als 115° sind.

12. Elektronenmikroskop mit einem Elektronenenergiefilter nach einem der Ansprüche 1 bis 11.

## Claims

1. Imaging electron energy filter which images a first entry plane (Be) into a first exit plane (Ba) achromatically and, concurrently, a second entry plane (De) into a second exit plane (Da) dispersively, with several sector magnets (1, 2, 3) for deflecting the beam, wherby at least a first sector magnet (1) provides a homogeneous deflecting field, characterized in that at least a second sector magnet (2, 3) provides an inhomogeneous deflecting field.

2. Electron energy filter of claim 1, wherein at least three sector magnets (1, 2, 3) are provided and at least two sector magnets (2, 3) each provide an inhomogeneous deflecting field.

3. Electron energy filter of claim 1 or 2, wherein the optical axis (4) passes the homogeneous deflecting field when entering into and when exiting from said electron energy filter and touches itself or crosses itself twice in the homogeneous deflecting field.

4. Electron energy filter of one of the claims 1 to 3, wherein the second or the second and third sector magnet (2, 3) each comprise a gap between the pole shoe faces (2a, 2f) which begins at an intersection point (12) and becomes wider in radial direction.

5. Electron energy filter of claim 4, wherein the pole shoes of the second and third sector magnet (2, 3) are configured as segments of truncated double cones (2a, 2f).

6. Electron energy filter of one of the claims 1 to 5, wherein the optical axis (4) is coaxial to itself when entering into and when exiting the filter and wherein the sector magnets (1, 2, 3) are arranged symmetrically to a plane (5) which is perpendicular to the optical axis (4).

7. Electron energy filter of one of the claims 1 to 6, wherein the sector magnets (1, 2, 3) each have straight entry edges and straight exit edges (1d, 2d, 3d, le, 2e, 3e, 1f) and wherein the entry and exit angles between the optical axis (4) and the entry edges and the exit edges (1d, 2d, 2e, 3d, 3e, 1f) of the sector magnets (1, 2, 3) amount to 90° at the first entry into the homogeneous deflecting field, at the entry in and the exit out of the inhomogeneous deflecting field and at the last exit from the homogeneous deflecting field.

8. Electron energy filter of claim 6 or 7, wherein several multipole lenses (6a, 7a, 8a, 9, 8b, 7b, 6b) are arranged outside the magnetic deflecting fields symmetrically to the symmetry plane (5) and wherein multipole lenses (6a, 6b; 7a, 7b; 8a, 8b) which are arranged symmetrically one to another are coupled one to another with respect to their excitation.

9. Electron energy filter of one of the claims 6 to 8, wherein multipole lenses (10, 11) are arranged, in the direction of the entering optical axis (4), in front of the entry image plane (Be) and behind the exit image plane (Ba) which is symmetrically to the entry image plane and which multipole lenses each comprise a superposition of a quadrupole and a hexapole and wherein the quadrupole field and the hexapole field are adjustable independently of each other.

10. Electron energy filter of claim 8, wherein the multipole lenses (6a, 7a, 8a, 9, 8b, 7b, 6b) arranged between the sector magnets (1, 2, 3) are configured as hexapols.

11. Electron energy filter of one of the claims 1 to 10, wherein the deflecting angles in each deflecting field are larger than 90°, preferably larger than 115°.

12. Electron microscope having an electron energy filter of one of the claims 1 to 11.

## Revendications

1. Filtre d'énergie électronique à formation d'image qui reproduit un premier plan d'entrée (Be) sous forme achromatique dans un premier plan de sortie (Ba) et simultanément un second plan d'entrée (De) sous forme dispersive dans un second plan de sortie (Da) avec plusieurs aimants sectoriels (1, 2, 3) qui dévient le faisceau électronique de telle manière qu'au moins un premier aimant sectoriel (1) présente un champ de déflexion homogène, caractérisé en ce qu'au moins un second aimant sectoriel (2, 3) présente un champ de déflexion non homogène.

2. Filtre d'énergie électronique selon la revendication 1, tel qu'au moins trois aimants sectoriels (1, 2, 3) sont prévus et qu'au moins deux aimants sectoriels (2, 3) présentent respectivement un champ de déflexion non homogène.

3. Filtre d'énergie électronique selon les revendications 1 ou 2, tel que l'axe optique (4) traverse le champ de déflexion homogène lorsqu'il pénètre dans le filtre d'énergie électronique, puis qu'il en ressort, et qu'il se touche ou se croise deux fois dans le champ de déflexion homogène.

4. Filtre d'énergie électronique selon l'une des revendications de 1 à 3, tel que le deuxième ou bien le deuxième et le troisième aimants sectoriels (2, 3) présentent respectivement une fente qui s'écarte radialement à partir du point d'intersection (12) entre les faces des pièces polaires (2a, 2f).

5. Filtre d'énergie électronique selon la revendication 4, tel que les pièces polaires des deuxième et troisième aimants sectoriels (2, 3) sont reproduites sous la forme de faces sectorielles coniques aplaties.

6. Filtre d'énergie électronique selon l'une des revendications de 1 à 5, tel que l'axe optique (4) évolue selon un trajet coaxial lorsqu'il entre dans le filtre, puis en ressort, et que les aimants sectoriels (1, 2, 3) sont disposés symétriquement par rapport à un plan (5), situé perpendiculairement au plan de l'axe optique (4).

7. Filtre d'énergie électronique selon l'une des revendications de 1 à 6, tel que les aimants sectoriels (1, 2, 3) présentent respectivement des bords d'attaque et de fuite rectilignes (1d, 2d, 3d, le, 2e, 3e, 1f) et tel que les angles d'incidence et d'émergence décrits entre l'axe optique (4) et les bords d'attaque et de fuite (1d, 2d, 2e, 3d, 3e, 1f) des aimants sectoriels (1, 2, 3) s'élèvent respectivement à 90°, au moment où le faisceau pénètre dans le champ de déflexion homogène, qu'il entre dans les champs de déflexion non homogènes et en ressort, enfin qu'il quitte une dernière fois le champ de déflexion homogène.

8. Filtre d'énergie électronique selon la revendication 6 ou 7, tel que plusieurs lentilles multipolaires (6a, 7a, 8a, 9, 8b, 7b, 6b) situées en dehors des champs de déflexion magnétiques sont disposées symétriquement par rapport au plan de symétrie (5) et que des lentilles multipolaires (6a, 6b; 7a, 7b; 8a, 8b) agencées respectivement en symétrie les unes par rapport aux autres sont couplées entre elles par le courant d'excitation.

9. Filtre d'énergie électronique selon l'une des revendications de 6 à 8, tel que des lentilles multipolaires (10, 11), constituées chacune par la superposition d'un quadripôle et d'un hexapôle, sont disposées devant un plan d'image d'entrée (Be) et symétriquement derrière le plan d'image de sortie (Ba) dans le sens de l'axe optique incident (4) et que le champ quadripolaire est réglable indépendamment du champ hexapolaire et vice versa.

10. Filtre d'énergie électronique selon la revendication 8, tel que les lentilles multipolaires (6a, 7a, 8a, 9, 8b, 7b, 6b), disposées entre les aimants sectoriels (1, 2, 3), présentent une configuration hexapolaire.

11. Filtre d'énergie électronique selon l'une des revendications de 1 à 10, tel que les angles de déviation sont supérieurs à 90°, qu'ils dépassent même de préférence 115° dans chaque champ de déflexion.

12. Microscope électronique muni d'un filtre d'énergie électronique selon l'une des revendications de 1 à 11.
